# EUROPEAN PATENT APPLICATION

(11) **EP 4 152 398 A1**
(43) Date of publication of application: **22.03.2023**
(21) Application number: 21821083.9
(22) Date of filing: 10.06.2021
(51) Int. Cl.: H01L 27/15, H01L 27/12

(54) **DISPLAY PANEL, DISPLAY APPARATUS, AND PREPARATION METHOD FOR DISPLAY PANEL**

(30) Priority: 10.06.2020 CN 202010522792
(71) Applicant: Huawei Technologies Co., Ltd., Longgang District, Shenzhen, Guangdong 518129 (CN)
(72) Inventor: QU, Shuang, Shenzhen, Guangdong 518129 (CN); DAI, Yufeng, Shenzhen, Guangdong 518129 (CN); SHAO, Jinyu, Shenzhen, Guangdong 518129 (CN)
(74) Representative: Isarpatent
(86) International application number: PCT/CN2021/099469
(87) International publication number: WO 2021/249497

(57) **Abstract**

This application provides a display panel, a display apparatus, and a preparation method for a display panel. The display panel includes a plurality of pixel units, and each pixel unit includes at least three color subpixels. All subpixels of the pixel unit are packaged into one pixel unit by a passivation layer. Packaging and a transfer at the passivation layer are performed per pixel unit. Compared with transferring a single subpixel, this greatly reduces a quantity of pixel transfers, and reduces a probability of product damage in a transfer process, thereby helping improve manufacturing efficiency and a product yield. In addition, all subpixels of each pixel unit may share one electrode, to be specific, one ends of the subpixels of the pixel unit each are connected to one first electrode, and the other ends of the subpixels of the pixel unit share one second electrode. This can reduce a total quantity of electrodes of the display panel, reduce a quantity of electrodes that need to be welded when the pixel unit is transferred to a substrate with a drive circuit, improve process efficiency, and also improve a yield of the display panel.

## Description

### CROSS-REFERENCE TO RELATED APPLICATIONS

This application claims priority to Chinese Patent Application No. 202010522792.4, filed with the China National Intellectual Property Administration on June 10, 2020 and entitled "DISPLAY PANEL, DISPLAY APPARATUS, AND PREPARATION METHOD FOR DISPLAY PANEL", which is incorporated herein by reference in its entirety.

### TECHNICAL FIELD

This application relates to the field of display apparatus technologies, and in particular, to a display panel, a display apparatus, and a preparation method for a display panel.

### BACKGROUND

With development of display technologies, displays are configured in an increasing quantity of scenarios and devices, to implement a display function and facilitate human-computer interaction. Especially in a mobile terminal, a display almost becomes an indispensable configuration. Therefore, the display technologies are developing constantly. Especially for a color display technology, performance in various aspects are constantly improved, and there is still large room for improvement.

In conventional display technologies, mature technologies include an LCD (liquid crystal display) technology and an OLED (organic light emitting diode) technology. An optical path of a display module of an LCD is complex, flexible bending is difficult to implement, and color display needs to be implemented by using a color film in combination with a backlight module. Therefore, color saturation of the LCD is difficult to reach a high level. For a display module of an OLED, currently, there is still a problem that a resolution, efficiency, brightness, and a service life of the OLED are difficult to improve. In addition, currently, a micro-LED (micro light emitting diode) technology has specific advantages in terms of optical efficiency, brightness, a response speed, and reliability, and has attracted increasing attention from persons in the art, but also has some problems.

### SUMMARY

This application provides a display panel, a display apparatus, and a preparation method for a display panel, to prepare a color function layer by using a lithography device for preparing an LED wafer, so that high-density pixels can be prepared on the wafer, and manufacturing costs can be reduced. In addition, in this solution, a quantity of pixel transfers is greatly reduced, and a probability of product damage in a transfer process is reduced, thereby helping improve manufacturing efficiency and a product yield.

According to a first aspect, this application provides a display panel. The display panel includes a plurality of pixel units, and each pixel unit includes at least three color subpixels. For example, the pixel unit includes a red subpixel, a green subpixel, and a blue subpixel, to implement color display on the display panel; or the pixel unit may include a red subpixel, a green subpixel, a blue subpixel, and a white subpixel, to help improve brightness of the display panel. All subpixels of the pixel unit are packaged into one pixel unit by a passivation layer, so that when the display panel is prepared, an LED wafer is first prepared, and then a color function layer of subpixels is prepared on a surface of the LED wafer. Therefore, in this solution, the color function layer may be prepared by using a lithography device for preparing an LED wafer. In this case, high-density pixels can be prepared on the wafer, and manufacturing costs can be reduced. In addition, packaging and a transfer at the passivation layer are performed per pixel unit. Compared with transferring a single subpixel, this greatly reduces a quantity of pixel transfers, and reduces a probability of product damage in a transfer process, thereby helping improve manufacturing efficiency and a product yield. In addition, all subpixels of each pixel unit may share one electrode, to be specific, one ends of the subpixels of the pixel unit each are connected to one first electrode, and the other ends of the subpixels of the pixel unit share one second electrode. In this solution, because packaging and a transfer are performed per pixel, designing all subpixels of a pixel unit into a structure with a shared electrode can reduce a total quantity of electrodes of the display panel, reduce a quantity of electrodes that need to be welded when the pixel unit is transferred to a substrate with a drive circuit, improve process efficiency, and also improve a yield of the display panel. In addition, costs for preparing electrodes can also be reduced.

Specifically, when the pixel unit is prepared, the first electrode may be an N electrode, and the second electrode may be a P electrode; or the first electrode is a P electrode, and the second electrode is an N electrode. This is not specifically limited in this application.

When the subpixel is specifically prepared, the subpixel may have at least two sub-subpixels, and the at least two sub-subpixels are arranged in parallel, to be specific, all sub-subpixels of each subpixel share a same group of N electrode and P electrode. Therefore, when a sub-subpixel of the subpixel is disconnected, a remaining sub-subpixel can still operate, and a voltage increases, so that brightness of the subpixel does not change much. When a sub-subpixel of the subpixel is short-circuited, the short-circuited sub-subpixel may be disconnected through human intervention, to form an open circuit, so that the subpixel still operates normally. In this solution, a service life and a yield of the subpixels can be improved, and a repair rate of the subpixels can also be increased, thereby reducing costs of the display panel and improving user experience.

The subpixels of the pixel unit include at least a red subpixel and a green subpixel, and may further include a blue subpixel and/or a white subpixel. Because the red subpixel has low light emitting efficiency in the case of a small size, a quantity of red subpixels may be made to be greater than a quantity of green subpixels. For example, the subpixels may include two red subpixels, one green subpixel, and one blue subpixel. Therefore, light emitting efficiency of all subpixels of the pixel unit can be consistent, thereby improving color saturation of the display panel.

To prevent light mixing between subpixels, a light shielding barrier may be disposed between subpixels. Specifically, an aluminum light shielding barrier may be disposed on peripheries of the subpixels. In addition to shielding light, the aluminum light shielding barrier has a specific light reflection effect, so that brightness and light emitting efficiency of the subpixels can be improved.

In a further technical solution, the aluminum light shielding barrier may be connected to the first electrode or the second electrode of the subpixels. The aluminum light shielding barrier serves as a wire, so that a wire design can be simplified when the pixel unit is prepared. Particularly, for a solution in which the first electrode and the second electrode of the pixel unit are disposed on a same side, the aluminum light shielding barrier may alternatively replace a wire passing through a thickness direction of the pixel unit, to increase an occupancy proportion of LEDs in the display panel, and improve light emitting efficiency and a display effect of the display panel.

The pixel unit includes an LED layer and the color function layer. The LED layer includes an N-type region layer, a multi-quantum-well layer, and a P-type region layer that are sequentially arranged. In adjacent subpixels of the pixel unit, there is a light shielding barrier between the multi-quantum-well layer and the P-type region layer, and the N-type region layer of the pixel unit is an integrated N-type region layer. In this solution, the subpixels of the pixel unit may share the N electrode. The N electrode and the N-type region layer may be connected to simplify a connection structure of the N electrode and the LED. In addition, the N electrode may be connected to a middle region of the N-type region layer of the pixel unit, so that electrons of the pixel unit do not easily flow to edges of the subpixels, thereby reducing a risk of current leakage of the subpixels.

Alternatively, in another technical solution, in adjacent subpixels of the pixel unit, there may be a light shielding barrier between the multi-quantum-well layer and the N-type region layer, and the P-type region layer of the pixel unit may be an integrated P-type region layer. In this solution, the P electrode serves as a shared electrode, and a technical effect is similar to that of the foregoing technical solution. Details are not described herein.

The pixel unit includes the LED layer and the color function layer, and includes a reflection layer on a side, of the LED layer, that is away from the color function layer. The reflection layer may reflect, to the color function layer, light that is emitted by the LED layer to the reflection layer, to improve light utilization efficiency. The reflection layer may be specifically a first distributed Bragg reflector layer or a metal reflection layer, and a specific type may be designed according to a requirement.

A second distributed Bragg reflector layer may be further provided on a side, of the LED layer, that faces the color function layer, and the second distributed Bragg reflector layer may transmit blue light, and reflect red light and green light, to improve photoelectric conversion efficiency of the pixel unit.

According to a second aspect, this application further provides a display apparatus. The display apparatus includes a middle frame, a rear housing, a printed circuit board, and the display panel in any one of the foregoing technical solutions. When the display apparatus is specifically mounted, the printed circuit board and the display panel are disposed on two sides of the middle frame. The middle frame is configured to carry the printed circuit board and the display panel. The rear housing is mounted on a side, of the printed circuit board, that is away from the middle frame, and may be specifically fastened to the middle frame. All subpixels of a pixel unit of the display panel of the display apparatus are packaged into one pixel unit by a passivation layer. In this solution, a color function layer of the pixel unit may be prepared by using a lithography device for preparing an LED wafer. In this case, high-density pixels can be prepared on the wafer, and manufacturing costs can be reduced. In addition, packaging and a transfer at the passivation layer are performed per pixel unit. This improves transfer efficiency, and reduces a probability of product damage in a transfer process, so that a yield and user experience of the display apparatus can be improved. All subpixels of each pixel unit may share one electrode, so that a total quantity of electrodes of the display panel can be reduced, a quantity of electrodes that need to be welded when the pixel unit is transferred to a substrate with a drive circuit can be reduced, process efficiency can be improved, and yields of the display panel and the display apparatus can also be improved.

According to a third aspect, this application further provides a preparation method for a display panel. The preparation method includes the following steps:
preparing a wafer, where the wafer includes an LED layer;
preparing a color function layer on a surface of the LED layer to form subpixels of a plurality of colors;
obtaining, through cutting, a barrier between pixel units to form a plurality of independent pixel units, where the pixel unit includes subpixels of at least three colors;
preparing a passivation layer on an outer surface of the pixel unit, and packaging subpixels of the pixel unit; and
transferring a pixel unit with the passivation layer to a substrate with a drive circuit to form a display panel.

In the preparation method for a display panel in this solution, a transfer may be performed to the substrate with the drive circuit per pixel unit, so that transfer efficiency can be improved, damage caused in a pixel unit transfer process can be reduced, and a yield of the display panel can be improved.

When the wafer is specifically prepared, the LED layer may be formed on a substrate, then a first electrode and a second electrode are prepared, the LED layer is cut to form independent LEDs, and subsequently a light shielding barrier is prepared between LEDs to prevent light mixing between adjacent LEDs.

After the wafer is prepared, the color function layer is prepared on the surface of the LED layer. In this case, the color function layer may be prepared directly by using a device for preparing a wafer. This helps improve density of prepared subpixels, reduce an investment in devices, and reduce costs.

The step of preparing a wafer may further include:
preparing the LED layer on a surface of the substrate, where a side, of the LED layer, that is away from the substrate is a reflection layer; and
forming the first electrode and the second electrode on a surface, of the reflection layer, that is away from the substrate.

The reflection layer is prepared on the LED layer, so that light emitted by the LEDs can be reflected to a light exit side, to improve light utilization efficiency. Specifically, the reflection layer may be a metal reflection layer or a first distributed Bragg reflector layer. When the first distributed Bragg reflector layer is selected as the reflection layer, no short circuit problem needs to be considered, and product reliability is high.

The step of preparing a wafer may further include:
preparing a second distributed Bragg reflector layer on a side, of the LED layer, that faces the color function layer.

In this solution, the second distributed Bragg reflector layer may transmit blue light, and reflect red light and green light, so that color saturation of the pixel unit can be improved.

In addition, to improve a service life and reliability of the subpixels, the step of preparing a wafer may further include: preparing an insulation layer at a specified position of each LED by using an ion implantation process, so that at least two parallel sub-LEDs are formed for the LED. In this solution, two sub-LEDs are connected in parallel. In this case, when preparation of a subpixel is completed, at least two parallel sub-subpixels can be formed for the subpixel. Therefore, when one sub-subpixel is disconnected or short-circuited, another sub-subpixel of the subpixel can remain in an operating state, to improve operating reliability and a service life of the subpixel.

Alternatively, to make at least two parallel sub-subpixels be formed for the subpixel, the step of preparing a wafer may further include:
performing cutting at a specified position of each LED, so that at least two parallel sub-LEDs are formed for the LED.

When the display panel is prepared, an aluminum light shielding barrier may be further provided between adjacent subpixels. During specific preparation, the following steps may be implemented:
the step of preparing a wafer includes: cutting the LED layer to form a plurality of LEDs, and preparing an aluminum light barrier between LEDs; and
the step of preparing a color function layer on a surface of the LED layer to form subpixels of a plurality of colors includes: preparing an aluminum light shielding barrier between subpixels.

In this solution, a surface of the aluminum light shielding barrier has a high light reflectivity. Therefore, when light emitted by the subpixel reaches the aluminum light shielding barrier, more light is reflected into the subpixel. This helps improve brightness and light emitting efficiency of the subpixel.

The aluminum light shielding barrier may be electrically connected to the first electrode or the second electrode of the subpixel. The aluminum light shielding barrier serves as a conducting wire. This can reduce a quantity of conducting wires disposed when the pixel unit is prepared, thereby simplifying a process and reducing costs. Especially when the first electrode and the second electrode of the pixel unit are located on a same side of the subpixels, one of the first electrode and the second electrode needs to be connected to the LED layer by using a wire passing through a thickness direction of the LED layer. Specifically, the aluminum light shielding barrier may be electrically connected to the electrode that needs to be connected to the wire passing through the thickness direction of the LED layer, so that no additional conducting wire passing through the LED layer needs to be prepared. This helps increase an occupancy proportion of the LEDs in the display panel, and helps improve light emitting efficiency and a display effect.

The preparing a wafer may further include: preparing the LED layer, where the LED layer includes an N-type region layer, a multi-quantum-well layer, and a P-type region layer that are sequentially arranged; and cutting the N-type region layer and the multi-quantum-well layer. In this solution, the P-type region layer may be retained as an integrated P-type region layer. In this solution, pixel units may share a P-type electrode, and the P-type electrode may be connected to the P-type region layer. This facilitates preparation of the P electrode. In addition, the P electrode may be electrically connected to a middle part of the P-type region layer, so that electrons of the pixel unit do not easily flow to edges of the subpixels, thereby reducing a risk of current leakage of the subpixels.

Alternatively, based on a same concept, the preparing a wafer may further include: preparing the LED layer, where the LED layer includes an N-type region layer, a multi-quantum-well layer, and a P-type region layer that are sequentially arranged; and cutting the P-type region layer and the multi-quantum-well layer, and retaining the N-type region layer as an integrated N-type region layer.

The subpixels of the pixel unit include at least a red subpixel and a green subpixel, and may further include a blue subpixel and/or a white subpixel. Because the red subpixel has low light emitting efficiency in the case of a small size, a quantity of red subpixels may be made to be greater than a quantity of green subpixels. For example, the subpixels may include two red subpixels, one green subpixel, and one blue subpixel. Therefore, light emitting efficiency of all subpixels of the pixel unit can be consistent, thereby improving color saturation of the display panel.

All subpixels of each pixel unit may share one electrode, to be specific, one ends of the subpixels of the pixel unit each are connected to one first electrode, and the other ends of the subpixels of the pixel unit share one second electrode. In this solution, because packaging and a transfer are performed per pixel, designing all subpixels of a pixel unit into a structure with a shared electrode can reduce a total quantity of electrodes of the display panel, reduce a quantity of electrodes that need to be welded when the pixel unit is transferred to a substrate with a drive circuit, improve process efficiency, and also improve a yield of the display panel. In addition, costs for preparing electrodes can also be reduced.

### BRIEF DESCRIPTION OF DRAWINGS

FIG. 1 is a schematic diagram of a structure of a display apparatus according to an embodiment of this application;
FIG. 2 is a schematic diagram of a partial structure of a display panel according to an embodiment of this application;
FIG. 3 is a schematic diagram of a structure of a subpixel according to an embodiment of this application;
FIG. 4 is a diagram of a circuit connection of two sub-subpixels of one subpixel according to an embodiment of this application;
FIG. 5 is a schematic diagram of a structure of a pixel unit according to an embodiment of this application;
FIG. 6 is a schematic diagram of a cross-sectional structure of a pixel unit according to an embodiment of this application;
FIG. 7 is a schematic diagram of a cross-sectional structure of a light emitting diode layer according to an embodiment of this application;
FIG. 8 is a schematic diagram of another cross-sectional structure of a pixel unit according to an embodiment of this application;
FIG. 9 is a schematic flowchart of a preparation method for a display panel according to an embodiment of this application;
FIG. 10 is a schematic diagram of a wafer preparation process according to an embodiment of this application;
FIG. 11a to FIG. 11h are schematic diagrams of a structure in a display panel preparation process according to an embodiment of this application;
FIG. 12 is a schematic diagram of a cross-sectional structure of a light emitting diode according to an embodiment of this application;
FIG. 13 is a schematic diagram of another cross-sectional structure of a light emitting diode according to an embodiment of this application;
FIG. 14 is a schematic diagram of a structure of a light emitting diode according to an embodiment of this application; and
FIG. 15 is a schematic diagram of a structure of a pixel unit according to an embodiment of this application.

### Reference numerals:

100: display apparatus; 200: display panel;
300: middle frame; 400: rear housing;
500: printed circuit board;
10: pixel unit; 11: subpixel;
111: sub-subpixel; 1111: first sub-subpixel;
1112: second sub-subpixel; 112: red subpixel;
113: green subpixel; 114: blue subpixel;
12: passivation layer; 13: first electrode;
14: second electrode; 15: N-type region layer;
16: multi-quantum-well layer; 17: P-type region layer;
18: light shielding barrier; 181: aluminum light shielding barrier;
19: LED layer; 191: light emitting function layer;
192: first distributed Bragg reflector layer; 193: second distributed Bragg reflector layer;
190: color function layer;
21: light emitting diode layer; 211: buffer layer;
212: GaN layer; 213: N-type doped GaN layer;
214: multi-quantum-well layer; 215: P-type AlGaN layer;
216: P-type doped GaN layer; 217: transparent electrode;
218: light emitting diode; 219: first light shielding barrier;
2110: color function layer; 2111: second light shielding barrier;
2112: first distributed Bragg reflector layer; 2113: second distributed Bragg reflector layer;
2114: N-type region layer; 2115: P-type region layer;
2116: aluminum light shielding barrier; 2117: ohmic contact layer;
2118: insulation layer; 22: first electrode;
23: second electrode; 24: pixel unit;
25: passivation layer; 30: substrate; and
40: tray; 50: adhesive.

### DESCRIPTION OF EMBODIMENTS

To make objectives, technical solutions, and advantages of this application clearer, the following further describes this application in detail with reference to the accompanying drawings.

For ease of understanding a display panel provided in embodiments of this application, the following first describes an application scenario of the display panel.

The display panel provided in embodiments of this application may be used in any display apparatus with a display function. The display apparatus may be a common mobile terminal, for example, a mobile phone, a tablet computer, or an e-book; or another electronic display apparatus, for example, a notebook computer, a television, or a device display. With development of display technologies, people pay increasing attention to a display effect and preparation costs of a display panel. A micro-LED (micro light emitting diode) technology has specific advantages in terms of optical efficiency, brightness, a response speed, and reliability, and the micro-LED technology has attracted increasing attention in the art. In a conventional technology, an LED board may be first prepared, and then a color conversion material layer is prepared on a surface of the LED board to prepare a color display panel. In this solution, there are mainly two technologies for covering the LED with the color conversion material layer: ink-jet printing and lithography. Pixel density that can be achieved based on precision of a conventional ink-jet printing device is approximately 200 ppi. This can hardly meet a display requirement of a current portable electronic product, for example, a smartphone, a smartwatch, or a tablet computer. However, when a lithography process is used, an expensive lithography device needs to be added. As a result, a large investment is required, and efficiency is low.

Based on the foregoing problems in the conventional technology, this application provides a display panel, a display apparatus, and a preparation method for a display panel, to improve pixel density of a display panel, reduce manufacturing costs, and improve manufacturing efficiency and a product yield.

Terms used in the following embodiments are merely intended to describe particular embodiments, but are not intended to limit this application. The terms "one", "a" and "this" of singular forms used in this specification and the appended claims of this application are also intended to include expressions such as "one or more", unless otherwise specified in the context clearly.

Referring to "an embodiment" or "some embodiments" or the like in this specification means that one or more embodiments of this application include a specific feature, structure, or characteristic described with reference to the embodiment. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

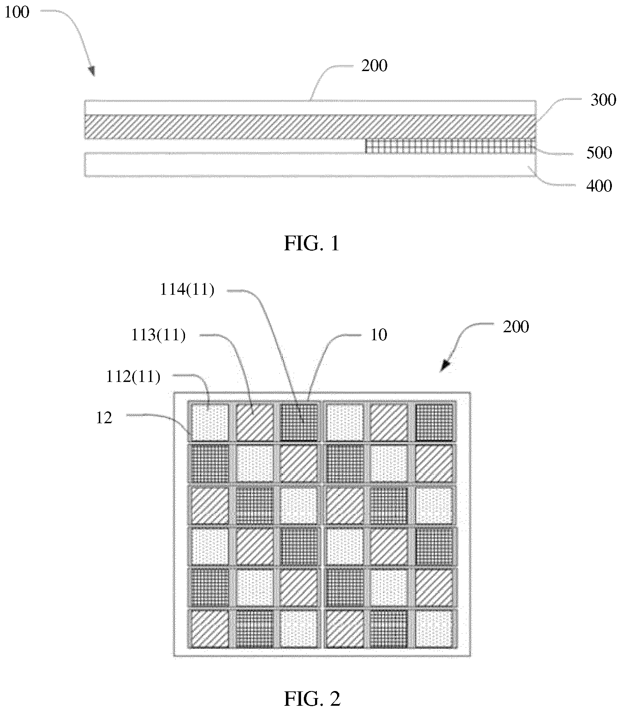

FIG. 1 is a schematic diagram of a structure of a display apparatus according to an embodiment of this application. A specific type of the display apparatus is not limited, and the display apparatus may be a common mobile terminal, for example, a mobile phone, a tablet computer, or an e-book; or another electronic display apparatus, for example, a notebook computer, a television, or a device display. The display apparatus 100 includes a display panel 200, a middle frame 300, a rear housing 400, and a printed circuit board 500. The display panel 200 is electrically connected to the printed circuit board 500, and the display panel 200 and the printed circuit board 500 are disposed on two sides of the middle frame 300. The middle frame 300 is configured to carry the printed circuit board and the display panel. The rear housing 400 is located on a side, of the printed circuit board 500, that is away from the middle frame 300, or may be fastened to the middle frame 300. Specifically, the display panel 200 may be a micro-LED (micro light emitting diode) display panel 200. FIG. 2 is a schematic diagram of a partial structure of a display panel according to an embodiment of this application. As shown in FIG. 2, the display panel 200 includes a plurality of pixel units 10, and each pixel unit 10 includes subpixels 11 of at least three colors. Specifically, the pixel unit 10 may include a red subpixel 112, a green subpixel 113, and a blue subpixel 114; or the pixel unit 10 may include a red subpixel 112, a green subpixel 113, a blue subpixel 114, and a white subpixel, to improve brightness of the pixel unit 10. The subpixels 11 of at least three colors are packaged into one pixel unit 10 by a passivation layer 12. In this case, when the display panel 200 is prepared, an LED wafer may be first prepared, and then a color function layer of the subpixels 11 is prepared on a surface of the LED wafer, to implement color display on the display panel 200. For example, the color function layer includes a light conversion material layer. Therefore, in this solution, the color function layer may be prepared by using a lithography device for preparing an LED wafer. In this case, high-density pixels can be prepared on the wafer, and no additional device needs to be prepared for fabricating the color function layer of the display panel, thereby helping reduce manufacturing costs. In addition, packaging and a transfer at the passivation layer 12 are performed per pixel unit 10. Compared with transferring a single subpixel 11, this greatly reduces a quantity of pixel transfers, and reduces a probability of product damage in a transfer process, thereby helping improve manufacturing efficiency and a product yield.

In each display panel 200, subpixels 11 of pixel units 10 may be arranged in a same manner or different manners. This is not specifically limited in this application. As shown in FIG. 2, subpixels 11 of the pixel units 10 are arranged in different manners. A material of the light conversion material layer may also be selected according to a requirement, for example, may be a quantum dot material, fluorescent powder, or an organic fluorescent dye. This is not specifically limited in this application either.

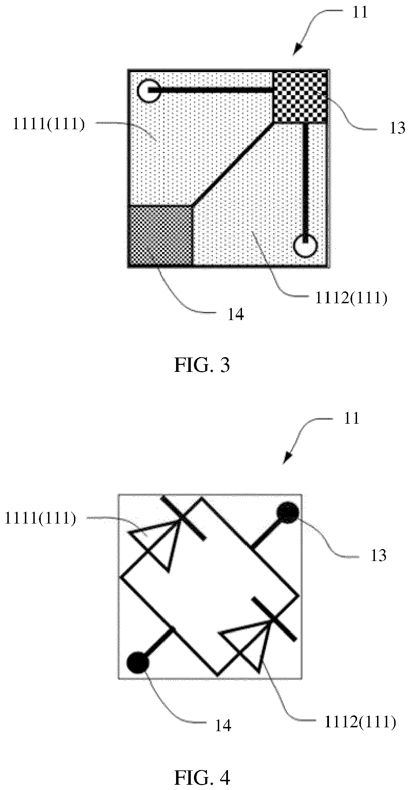

FIG. 3 is a schematic diagram of a structure of a subpixel according to an embodiment of this application. To improve a service life and a yield of the subpixel 11 and improve display reliability of the display panel 200 and a service life of the display panel 200, the subpixel 11 in this embodiment of this application may include at least two sub-subpixels 111. The at least two sub-subpixels 111 are arranged in parallel. FIG. 3 is used as an example in combination with FIG. 4. FIG. 4 is a diagram of a circuit connection of two sub-subpixels 111 according to an embodiment of this application. In a specific embodiment, the subpixel 11 may include a first sub-subpixel 1111 and a second sub-subpixel 1112, and further include a first electrode 13 and a second electrode 14. The first sub-subpixel 1111 and the second sub-subpixel 1112 are connected in parallel between the first electrode 13 and the second electrode 14. Therefore, in this solution, a probability that the subpixel 11 cannot be lit can be reduced.

If the first sub-subpixel 1111 is disconnected, the second sub-subpixel 1112 is still connected between the first electrode 13 and the second electrode 14, and can remain in an operating state. In addition, a power of the second sub-subpixel 1112 can be doubled, and brightness is increased. Therefore, brightness of the subpixel 11 can also be ensured, so that the subpixel 11 operates normally. If the first sub-subpixel 1111 is short-circuited, a circuit in which the first sub-subpixel 1111 is located may be cut by using a laser, so that the first sub-subpixel 1111 is disconnected. Therefore, the second sub-subpixel 1112 can still remain in an operating state. In addition, a power of the second sub-subpixel 1112 can be doubled, and brightness is increased. Therefore, brightness of the subpixel 11 can be ensured, so that the subpixel 11 operates normally. Therefore, in this solution, a service life and a yield of the subpixel 11 are improved, and a repair rate is high, thereby reducing costs of the display panel 200. A service life and user experience of the display apparatus 100 can also be improved.

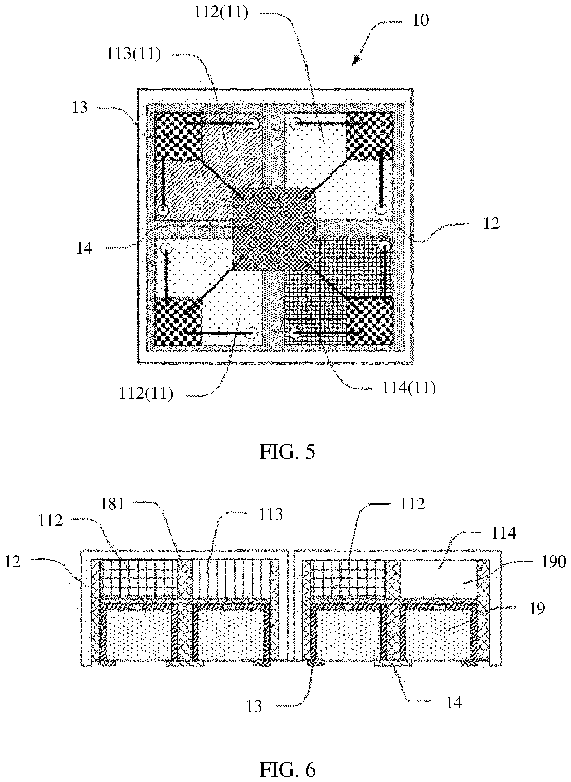

FIG. 5 is a schematic diagram of a structure of a pixel unit according to an embodiment of this application. As shown in FIG. 5, the pixel unit 10 includes a first electrode 13 and a second electrode 14, and the first electrode 13 and the second electrode 14 may be located on a same side of the subpixel 11. All subpixels 11 of each pixel unit 10 may be further designed to share one electrode. To be specific, one ends of all the subpixels 11 of the pixel unit 10 share one second electrode 14, and the other ends of the subpixels 11 each are connected to one first electrode 13. In this solution, because final cutting and a final transfer are performed per pixel unit 10, all subpixels 11 of the pixel unit 10 can share one second electrode 14. This can reduce a total quantity of electrodes of the display panel 200, and help reduce a quantity of electrodes that need to be welded when the pixel unit 10 is transferred to a substrate with a drive circuit. Therefore, process efficiency can be improved, and defects occurring in welding can be reduced. In addition, costs for preparing electrodes can also be reduced.

In a specific embodiment, the first electrode 13 may be a P electrode, and the second electrode 14 may be an N electrode; or the first electrode 13 is an N electrode, and the first electrode 13 is a P electrode. This is not specifically limited in this application.

Still refer to FIG. 5. The pixel unit 10 includes at least a red subpixel 112, a green subpixel 113, and a blue subpixel 114. Because the red subpixel 112 has low light emitting efficiency in the case of a small size, a quantity of red subpixels 112 is greater than a quantity of green subpixels 113, and the quantity of green subpixels 113 may be equal to a quantity of blue subpixels 114. For example, in the embodiment shown in FIG. 5, the pixel unit 10 may include two red subpixels 112, one green subpixel 113, and one blue subpixel 114. Because light emitting efficiency of the small-sized red subpixel 112 is lower than light emitting efficiency of the green subpixel 113 or the blue subpixel 114, the quantity of red subpixels 112 may be increased to improve color saturation, so that subpixels 11 of different colors have consistent efficiency.

In this embodiment of this application, there is a light shielding barrier 18 on a periphery of the subpixel 11. This can prevent light mixing between adj acent subpixels 11, and can also implement insulation between subpixels 11, so that the subpixels 11 remain independent. Specifically, a material of the light shielding barrier 18 is not specifically limited, for example, may be a polymer material, a metal, or a metal compound. The material of the light shielding barrier 18 only needs to have a light shielding property.

FIG. 6 is a schematic diagram of a cross-sectional structure of a pixel unit according to an embodiment of this application. There is an aluminum light shielding barrier 181 on the periphery of the subpixel 11, and a surface of the aluminum light shielding barrier 181 has a high light reflectivity. Therefore, when light emitted by the subpixel 11 reaches the aluminum light shielding barrier 181, more light is reflected into the subpixel 11. This helps improve brightness and light emitting efficiency of the subpixel 11. Specifically, the subpixel 11 may include an LED layer 19 and a color function layer 190. The LED layer 19 mainly generates light with specific brightness. The color function layer 190 located on a surface of the LED layer 19 may convert the light of the LED layer 19 into color light, to implement color display on the display panel 200. The aluminum light shielding barrier 181 can improve brightness of the LED layer 19, and can also enhance light conversion efficiency of the color function layer 190, thereby improving brightness and light emitting efficiency of the subpixel 11, and improving a display effect of the display panel 200.

In a specific embodiment, the aluminum light shielding barrier 181 may be connected to the first electrode 13 or the second electrode 14 of the subpixel 11. In this solution, the aluminum light shielding barrier 181 serves as a conducting wire. This can reduce a quantity of conducting wires disposed when the pixel unit 10 is prepared, thereby simplifying a process and reducing costs. When the first electrode 13 and the second electrode 14 of the pixel unit 10 are located on a same side of the subpixel 11, one of the first electrode 13 and the second electrode 14 needs to be connected to the LED layer 19 by using a wire passing through a thickness direction of the LED layer 19. Specifically, the aluminum light shielding barrier 181 may be electrically connected to the electrode that needs to be connected to the wire passing through the thickness direction of the LED layer 19, so that no additional conducting wire passing through the LED layer 19 needs to be prepared. This helps increase an occupancy proportion of the LEDs in the display panel 200, and helps improve light emitting efficiency and a display effect.

In addition, as shown in FIG. 5, all subpixels 11 of each pixel unit 10 may be further designed to share one electrode. To be specific, one ends of all the subpixels 11 of the pixel unit 10 share one second electrode 14, and the other ends of the subpixels 11 each are connected to one first electrode 13. When the aluminum light shielding barrier 181 is disposed between adjacent subpixels 11, the aluminum light shielding barrier 181 may be connected to the second electrode 14, so that one ends of the subpixels 11 of the pixel unit 10 share one second electrode 14. In this case, the aluminum light shielding barrier 181 may further serve as a wire for connecting to the shared electrode to reduce additional conducting wires.

In an optional embodiment, the LED layer 19 may be a blue LED layer or an ultraviolet LED layer. This is not specifically limited in this application. When the LED layer 19 is a blue LED layer, a color function layer 190 corresponding to the red subpixel 112 is provided with a red light conversion material, and a color function layer 190 corresponding to the green subpixel 113 is provided with a green light conversion material. However, a color function layer 190 corresponding to the blue subpixel 114 does not need to be provided with a light conversion material, and only a transparent film layer needs to be provided to make the color function layer 190 have good overall flatness. For example, the transparent film layer may be specifically a silicone gel layer.

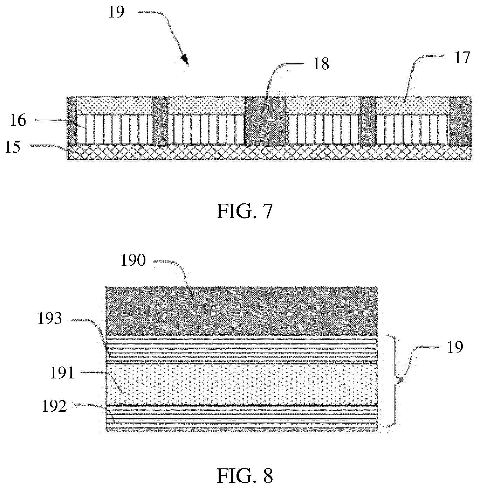

FIG. 7 is a schematic diagram of a cross-sectional structure of a light emitting diode layer according to an embodiment of this application. The LED layer 19 of the pixel unit 10 may include an N-type region layer 15, a multi-quantum-well layer 16, and a P-type region layer 17 that are sequentially arranged, and there is a light shielding barrier between adjacent subpixels 11. In this solution, the light shielding barrier may extend in a direction roughly perpendicular to the LED layer 19, and pass through the P-type region layer 17 and the multi-quantum-well layer 16, so that insulation, light shielding, and isolation are implemented between P-type region layers 17 of adjacent subpixels 11, and insulation, light shielding, and isolation are implemented between adjacent multi-quantum-well layers 16. The N-type region layer 15 of the pixel unit 10 has an integral structure. To be specific, N-type region layers 15 of all the subpixels 11 of the pixel unit 10 are in an integrated structure. Certainly, when the LED layer 19 of the pixel unit is specifically prepared, from a perspective of a preparation process, the light shielding barrier may extend into the N-type region layer 15 by a specific depth, to ensure that the multi-quantum-well layer 16 can be isolated by using the light shielding barrier, and improve operation reliability of the LED.

In this solution, the N electrode may be a shared electrode, and all the subpixels 11 of the pixel unit 10 share one N electrode. The N-type region layer 15 of the pixel unit 10 has an integrated structure, thereby facilitating preparation of the N electrode. In addition, the N electrode may be electrically connected to a middle part of the N-type region layer 15, so that electrons of the pixel unit 10 do not easily flow to edges of the subpixels 11, thereby reducing a risk of current leakage of the subpixels 11.

In another embodiment, alternatively, the light shielding barrier may extend in a direction roughly perpendicular to the LED layer 19, and pass through the N-type region layer 15 and the multi-quantum-well layer 16, so that insulation, light shielding, and isolation are implemented between N-type region layers 15 of adjacent subpixels 11, and insulation, light shielding, and isolation are implemented between adjacent multi-quantum-well layers 16. The P-type region layer 17 of the pixel unit 10 has an integral structure. To be specific, N-type region layers 15 of all the subpixels 11 of the pixel unit 10 are in an integrated structure. Likewise, when the LED layer 19 of the pixel unit is specifically prepared, from a perspective of a preparation process, the light shielding barrier may extend into the P-type region layer 17 by a specific depth, to ensure that the multi-quantum-well layer 16 can be isolated by using the light shielding barrier, and improve operation reliability of the LED. In this solution, the P electrode is a shared electrode, and a technical effect is similar to that of the foregoing embodiment. Details are not described herein.

FIG. 8 is a schematic diagram of another cross-sectional structure of a pixel unit according to an embodiment of this application. The pixel unit 10 includes an LED layer 19 and a color function layer 190. The LED layer 19 includes a light emitting function layer 191 and a first distributed Bragg reflector layer 192. The first distributed Bragg reflector layer 192 is located on a side, of the light emitting function layer 191, that is away from the color function layer, in other words, located on a side, of the LED layer 19, that is away from the color function layer 190. The first distributed Bragg reflector layer 192 can reflect blue light, thereby improving light emitting efficiency of the LED. The first distributed Bragg reflector layer 192 is provided, as a reflection layer, on the side, of the LED, that is away from the color function layer. Because the first distributed Bragg reflector layer 192 is made of an insulation material, a short circuit risk is low, thereby helping improve reliability of the display panel. Alternatively, the reflection layer may be a metal reflection layer, for example, a reflection layer made of aluminum. This is not specifically limited in this application.

The first distributed Bragg reflector layer 192 is made of two materials with different refractive indexes (for example, silicon dioxide and titanium dioxide), and the two materials are sequentially and alternately superposed. An optical thickness of each layer of material is 1/4 of a center reflection wavelength. To ensure that all light within a specified wavelength range is reflected, the first distributed Bragg reflector layer 192 includes a multilayer structure, and a total thickness is controlled to be less than 5 µm.

Specifically, in the foregoing another embodiment, a second distributed Bragg reflector layer is included on a side, of the LED layer 19, that faces the color function layer 190. In other words, the second distributed Bragg reflector layer is located on a side, of the light emitting function layer 191, that faces the color function layer 190. In this solution, the second distributed Bragg reflector layer 193 may transmit blue light, and reflect red light and green light, to improve photoelectric conversion efficiency of the pixel unit 10. The second distributed Bragg reflector layer 193 is also made of two materials with different refractive indexes (for example, silicon oxide and titanium oxide), and the two materials are sequentially and alternately superposed, to form a multilayer structure.

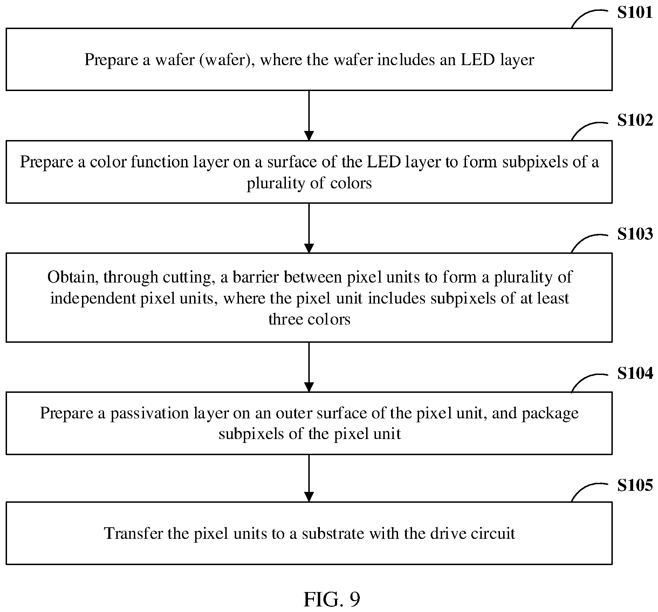

Based on a same inventive concept, this application further provides a preparation method for a display panel. FIG. 9 is a schematic flowchart of a preparation method for a display panel according to an embodiment of this application. The preparation method for the display panel 200 specifically includes the following steps.

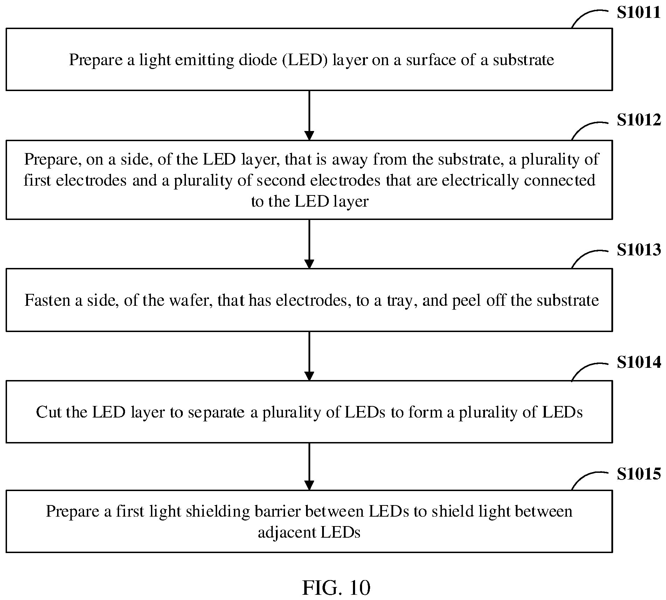

Step S101: Prepare a wafer (wafer), where the wafer includes an LED layer. FIG. 10 is a schematic diagram of a wafer preparation process according to an embodiment of this application. The process specifically includes the following steps.

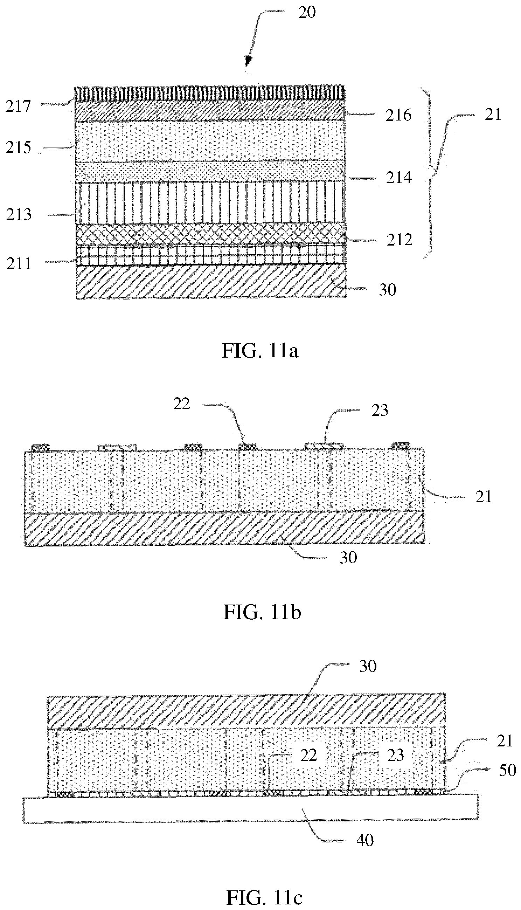

Step S1011: Prepare a light emitting diode (LED) layer 21 on a surface of a substrate 30, as shown in FIG. 11a.

The substrate 30 may be a sapphire substrate 30. The sapphire substrate 30 has low costs and adapts to a lattice of a material for preparing the LED layer 21, thereby facilitating formation of the LED layer 21. Certainly, in another embodiment, the substrate 30 may alternatively be a silicon substrate 30, a silicon carbide substrate 30, or a glass substrate 30. This is not limited in this application.

As shown in FIG. 11a, a specific process of preparing the LED layer 21 on the surface of the substrate 30 may include:
a buffer layer (GaN Buffer, gallium nitride buffer layer) 211 is prepared on the surface of the substrate 30, where a thickness of the buffer layer 211 may be 15 nm;
LEDs 218 sequentially grow on a surface, of the buffer layer 211, that is away from the substrate 30, where blue LEDs are used as an example:
   a GaN layer (undoped GaN, undoped gallium nitride layer) 212 grows on the surface, of the buffer layer 211, that is away from the substrate 30 at 350 to 500 degrees centigrade, where a thickness of the GaN layer 212 may be specifically 2 µm, and in a growth process, atmospheric pressure may be specifically 500 to 700 mBar, V/III is 2000 to 5000, and a growth rate is 3 to 15 nm/min, where V/III is a molar ratio of the fifth main group element N to the third main group element Ga, and the growth rate is an increase in a thickness of a substance generated within a given time;
   an N-type doped GaN layer (N doped GaN, gallium nitride doped with an N-type material) 213 grows on a surface, of the GaN layer 212, that is away from the buffer layer 211 at 450 to 500 degrees centigrade, where a thickness of the N-type doped GaN layer 213 may be 2 µm, and in a growth process, atmospheric pressure may be specifically 200 to 400 mBar, V/III is 6000 to 10000, and a growth rate is 0.5 to 8 µm/h;
   a multi-quantum-well layer (Multi Quantum Well) 214 grows on a surface, of the N-type doped GaN layer 213, that is away from the GaN layer 212 at 400 to 500 degrees centigrade, where the multi-quantum-well layer 214 is formed by superposing GaN (gallium nitride) and InGaN (indium gallium nitride); a specific quantity of the multi-quantum-well layers 214 is not limited, but both an uppermost layer and a lowermost layer are GaN, and adjacent quantum wells may reuse one GaN; a thickness of InGaN above may be 3 nm, and a thickness of GaN above may be 7 nm; and in a growth process, atmospheric pressure is 200 to 400 mBar, V/III is 12000 to 30000, and a growth rate is 0.5 to 3 µm/h;
   a P-type AlGaN layer (P-AlGaN electron block layer, P-type aluminum gallium nitride electron block layer) 215 grows on a surface, of the multi-quantum-well layer 214, that is away from the N-type doped GaN layer 213 at 400 to 500 degrees centigrade, where the P-type AlGaN layer 215 is an electron block layer for avoiding electron overcurrent and improving light emitting efficiency; a thickness of the P-type AlGaN layer 215 may be 80 nm; and in a growth process, atmospheric pressure may be 50 to 300 mBar, V/III may be 2000 to 5000, and a growth rate is 0.5 to 2 µm/h;
   a P-type doped GaN layer (P doped GaN, gallium nitride doped with a P-type material) 216 grows on a surface, of the P-type AlGaN layer 215, that is away from the multi-quantum-well layer 214 at 400 to 500 degrees centigrade, where a thickness may be 150 nm; and in a growth process, atmospheric pressure is 200 to 400 mBar, V/III is 6000 to 10000, and a growth rate is 0.5 to 8 µm/h; and
   a layer of transparent electrode 217, for example, an indium tin oxide thin film, is formed, through evaporation by using an evaporation process, on a surface, of the P-type doped GaN layer 216, that is away from the P-type AlGaN layer 215, where a thickness may be, for example, 1 µm.

Step S1012: Prepare, on a side, of the LED layer 21, that is away from the substrate 30, a plurality of first electrodes 22 and a plurality of second electrodes 23 that are electrically connected to the LED layer 21, as shown in FIG. 11b.

In this solution, the first electrodes 22 and the second electrodes 23 are disposed on a same side of the LED layer 21. This is a flip chip (flip chip) structure. The structure helps improve light emitting efficiency of the LEDs 218, and reduce a quantity of wires required for connecting the first electrodes 22 and the second electrodes 23 to a substrate with a drive circuit, thereby facilitating mounting. A material of the first electrodes 22 and the second electrodes 23 may be a multi-element alloy metal, for example, a SnAg alloy or a NiPtAu alloy. This is not specifically limited in this application. To form the first electrodes 22 and the second electrodes 23, a mask with a specified structure may be disposed on the side, of the LED layer 21, that is away from the substrate 30, and the first electrodes 22 and the second electrodes 23 may be formed through evaporation.

Step S 1013: Fasten a side, of the wafer, that has electrodes, to a tray 40, and peel off the substrate 30, as shown in FIG. 11c.

During specific implementation of this step, the wafer may be bonded to the tray 40 by using an adhesive 50, and the substrate 30 may be peeled off by using a laser cutting process.

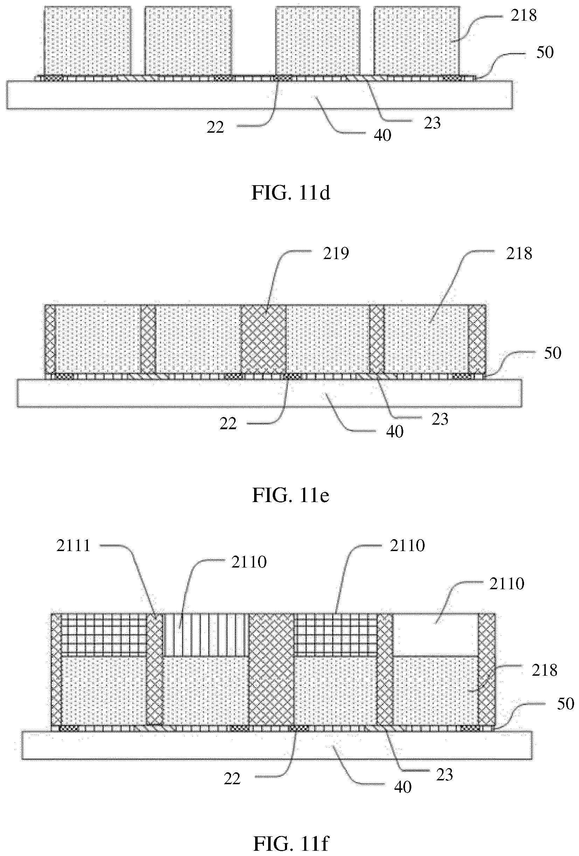

Step S1014: Cut the LED layer 21 to separate a plurality of LEDs 218 to form a plurality of LEDs 218, as shown in FIG. 11d.

Specifically, a region between the plurality of LEDs 218 may be etched by using an ICP process to separate the LEDs 218 to form a plurality of LEDs 218 that can be driven independently.

Step S1015: Prepare a first light shielding barrier 219 between LEDs 218 to shield light between adjacent LEDs 218, as shown in FIG. 11e.

When the LED layer 21 is cut, there is a gap between LEDs 218. The gap may be filled with black photoresist resin through spin coating, then the black photoresist resin in the gap region between LEDs 218 is photocured by using a mask, and then excess black photoresist resin is cleaned. In this way, the first light shielding barrier 219 can be formed, to prevent light diffusion between different LEDs 218. A material for preparing the first light shielding barrier 219 is not limited, for example, may be a polymer material, a metal, or a metal compound. The material of the first light shielding barrier 219 only needs to have a light shielding property.

Step S102: Prepare a color function layer 2110 on a surface of the LED layer 21 to form subpixels of a plurality of colors, as shown in FIG. 11f.

Specifically, the color function layer 2110 may be prepared on a side, of the LEDs 218, that is away from the first electrodes 22, to form a red subpixel, a green subpixel, and a blue subpixel.

After the LEDs 218 are prepared, the color function layer 2110 may be directly prepared, so that a lithography device for preparing a wafer can be used. This can reduce costs and reduce an investment in devices while improving preparation precision. The color function layer 2110 includes a light conversion material layer. A material of the light conversion material layer is not limited, and may be a quantum dot material, fluorescent powder, an organic fluorescent dye, or the like. Specifically, the quantum dot material may be selected, and a color film is further provided on a side, of the quantum dot material, that is away from the LEDs 218. Specifically, a thickness of a light conversion material layer prepared by using the quantum dot material may be 4 µm, and a thickness of the color film may be 2 µm. During specific processing, by using the red subpixel as an example, a process of preparing the light conversion material layer may be as follows: First, a lithography adhesive of a red quantum dot material is applied to a surface of the entire wafer through spin coating. Then photosensitive curing is performed at a required position (above an LED 218 corresponding to the red subpixel) by using a lithography plate. Finally, an uncured lithography adhesive of the red quantum dot material is cleaned. With the same process, a color film may be prepared on a side, of the light conversion material layer, that is away from the LED layer 21 by using a same process as that of the red subpixel.

There is a gap between regions corresponding to the color function layer 2110 and each LED 218. The gap may be filled with black photoresist resin through spin coating, then the black photoresist resin in the gap region is photocured by using a mask, and then excess black photoresist resin is cleaned. In this way, a second light shielding barrier 2111 can be formed between adjacent subpixels to prevent light diffusion between different subpixels. A material for preparing the second light shielding barrier 2111 is not limited, for example, may be a polymer material, a metal, or a metal compound. The material of the second light shielding barrier 2111 only needs to have a light shielding property.

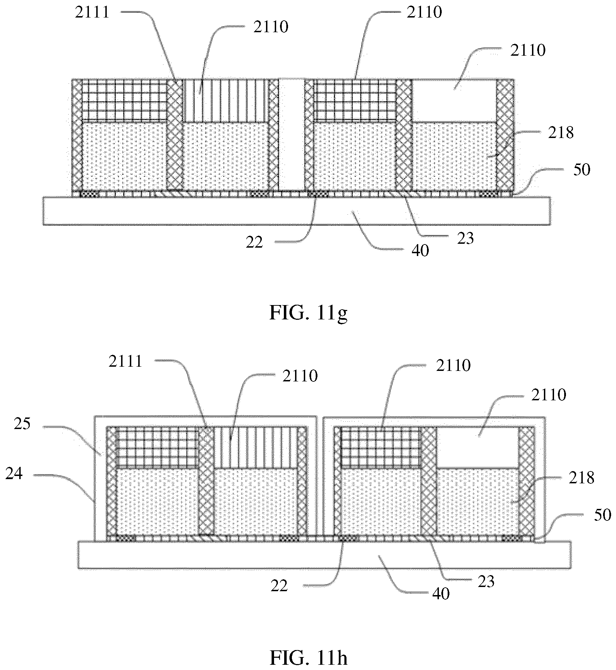

Step S103: Obtain, through cutting, a barrier between pixel units 24 to form a plurality of independent pixel units 24, where the pixel unit 24 includes subpixels of at least three colors, as shown in FIG. 11g.

The pixel unit 24 may specifically include a red subpixel, a green subpixel, and a blue subpixel; or may include a red subpixel, a green subpixel, a blue subpixel, a white subpixel, and the like. This is not specifically limited in this application. Cutting is performed per pixel unit 24, and independent pixel units 24 are formed through cutting. In this case, when the display panel is prepared, the pixel units 24 may be directly transferred to the substrate with the drive circuit, without separately transferring each subpixel, so that a quantity of transfers can be greatly reduced. Specifically, the pixel units 24 may be cut by using a mask in combination with a dry etching process.

Step S 104: Prepare a passivation layer 25 on an outer surface of the pixel unit 24, and package subpixels of the pixel unit 24, as shown in FIG. 11h.

The passivation layer 25 may be a passivation layer 25 obtained through evaporation on a chip surface in a PECVD (Plasma Enhanced Chemical Vapor Deposition, plasma enhanced chemical vapor deposition) manner. A thickness of the passivation layer 25 may be several hundreds of nanometers, and a material may be an inorganic passivation material, for example, silicon dioxide or silicon nitride.

Step S 105: Transfer the pixel units 24 to the substrate with the drive circuit.

A transfer is performed to the substrate with the drive circuit per pixel unit 24, so that a quantity of transfers can be greatly reduced, thereby helping improve transfer efficiency and a product yield.

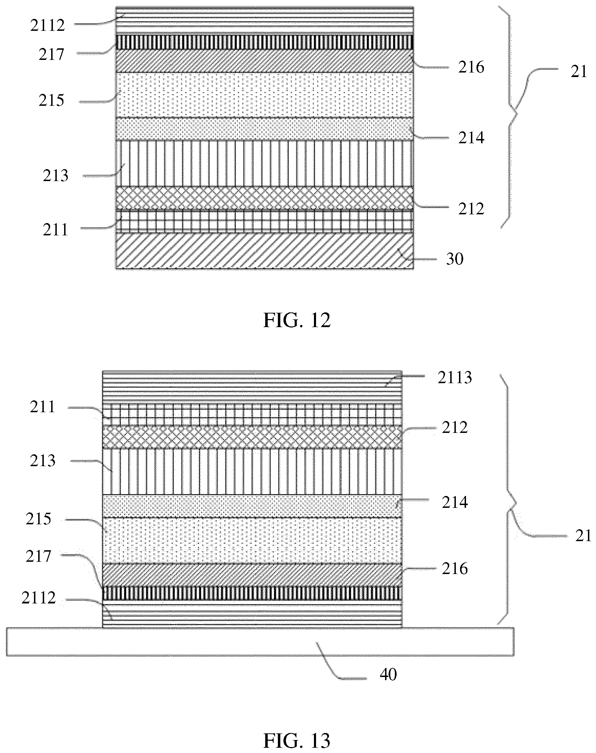

Step S101 may further include a process of preparing a reflection layer. Specifically, in step S1011, a layer of transparent electrode 217 may be generated, through evaporation by using an evaporation process, on a surface, of the P-type doped GaN layer 216, that is away from the AlGaN layer. Then a first distributed Bragg reflector layer 2112 is prepared as a reflection layer on a surface, of the transparent electrode 217, that is away from the P-type doped GaN layer 216, as shown in FIG. 12. FIG. 12 is a schematic diagram of a cross-sectional structure of a light emitting diode according to an embodiment of this application. Then step S1012 is performed to form a plurality of first electrodes 22 and a plurality of second electrodes 23 on a surface, of the first distributed Bragg reflector layer 2112, that is away from the substrate 30. The first distributed Bragg reflector layer 2112 may reflect blue light, thereby improving light emitting efficiency of the LED 218.

Specifically, a process of preparing the first distributed Bragg reflector layer 2112 may include: Two materials with different refractive indexes, for example, silicon oxide and titanium oxide, are sequentially and alternately superposed, where an optical thickness of each layer of material is 1/4 of a wavelength of to-be-reflected light. To ensure that all light within a specified wavelength range is reflected, the first distributed Bragg reflector layer 2112 includes a multilayer structure, and a total thickness is controlled to be less than 5 µm.

Alternatively, the reflection layer may be a metal reflection layer, for example, an aluminum reflection layer. When the metal reflection layer is prepared, insulation processing needs to be performed, to prevent the metal reflection layer from causing a short circuit problem.

In a further embodiment, in step S101, a second distributed Bragg reflector layer 2113 may be further prepared on a side, of the LED layer 21, that faces the color function layer 2110. Specifically, after step S1013, the second distributed Bragg reflector layer 2113 may be prepared on the LED layer 21, as shown in FIG. 13. FIG. 13 is a schematic diagram of another cross-sectional structure of a light emitting diode according to an embodiment of this application. In this solution, the second distributed Bragg reflector layer 2113 may transmit blue light, and reflect red light and green light, so that color saturation of the pixel unit 24 can be improved. A thickness of the second distributed Bragg reflector layer 2113 may be about 2.5 µm. A process of preparing the second distributed Bragg reflector layer 2113 is roughly the same as the process of preparing the first distributed Bragg reflector layer 2112. Details are not described again in this application.

In another technical solution, the light emitting function layer of the LED layer 21 may be located between the first distributed Bragg reflector layer 2112 and the second distributed Bragg reflector layer 2113, as shown in FIG. 13. In this solution, light emitting efficiency of the LED 218 is high.

To implement that the subpixel includes at least two sub-subpixels and the at least two sub-subpixels are arranged in parallel, when the wafer is prepared in step S101, an insulation layer may be prepared at a specified position of each LED 218 by using an ion injection process, so that at least two parallel sub-LEDs 218 are formed for each LED 218. In this solution, in the ion injection process, ions with an insulation property may be injected into the LED 218 to form the insulation layer. For example, helium ions or nitrogen ions may be injected into the LED to form the insulation layer. Specifically, when the insulation layer is prepared, a part, of a mark, into which ions need to be injected may be prepared first, and then He ions of a specific dose are injected to form an insulation layer with a very high insulativity and inactivity in the LED 218, so that LEDs 218 on two sides of the insulation layer are sub-LEDs 218 and are connected in parallel.

In another embodiment, cutting may alternatively be performed at a specified position of each LED 218, so that at least two parallel sub-LEDs 218 are formed for each LED. The cutting step may be performed simultaneously with step S1014.

The first electrode 22 and the second electrode 23 of the pixel unit 24 may be located on a same side of the subpixels. All subpixels of each pixel unit 24 may be designed to share one electrode. To be specific, one ends of all the subpixels of the pixel unit 24 share one second electrode 23, and the other ends of the subpixels each are connected to one first electrode 22. In this solution, because final cutting and a final transfer are performed per pixel unit 24, all the subpixels of the pixel unit 24 can share one second electrode 23. This can reduce a total quantity of electrodes of the display panel, and help reduce a quantity of electrodes that need to be welded when the pixel unit 24 is transferred to the substrate with the drive circuit. Therefore, process efficiency can be improved, and defects occurring in welding can be reduced. Costs for preparing electrodes can also be reduced.

In a specific embodiment, the first electrode 22 may be a P electrode, and the second electrode 23 may be an N electrode; or the first electrode 22 is an N electrode, and the first electrode 22 is a P electrode. This is not specifically limited in this application.

The pixel unit 24 includes at least a red subpixel, a green subpixel, and a blue subpixel. Because the red subpixel has low light emitting efficiency in the case of a small size, a quantity of red subpixels is greater than a quantity of green subpixels, and the quantity of green subpixels may be equal to a quantity of blue subpixels. For example, the pixel unit may include two red subpixels, one green subpixel, and one blue subpixel. Because light emitting efficiency of the small-sized red subpixel is lower than light emitting efficiency of the green subpixel or the blue subpixel, the quantity of red subpixels may be increased to improve color saturation, so that subpixels of different colors have consistent efficiency.

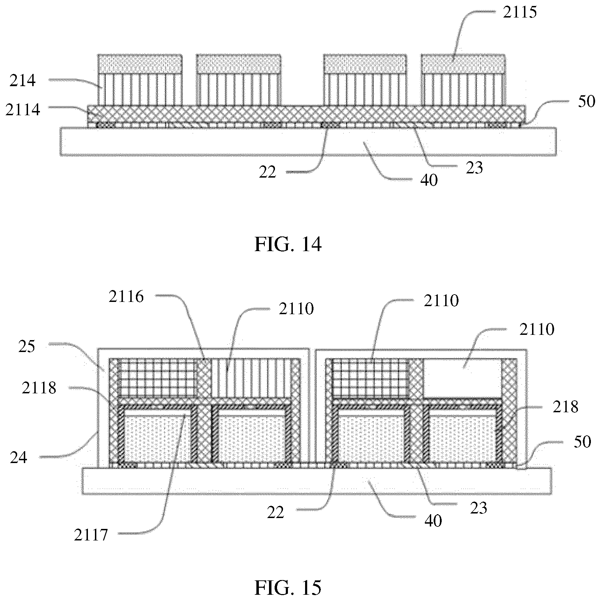

FIG. 14 is a schematic diagram of a structure of a light emitting diode according to an embodiment of this application. The LED layer 21 includes an N-type region layer 2114, a multi-quantum-well layer 214, and a P-type region layer 2115 that are sequentially arranged. The preparing a wafer includes: cutting the LED layer 21 to form a plurality of LEDs 218. Specifically, the multi-quantum-well layer 214 and the P-type region layer 2115 may be cut, and the N-type region layer 2114 is retained as an integrated N-type region layer. When this step is specifically performed, the N-type region layer 2114 may be cut by a specific depth, to ensure that the multi-quantum-well layer 214 can be completely cut through, thereby preventing interference between adjacent LEDs, and improving operation reliability of the LEDs.

In this solution, the N electrode may be a shared electrode, and all the subpixels of the pixel unit 24 share one N electrode. The N-type region layer 2114 of the pixel unit 24 has an integrated structure, thereby facilitating preparation of the N electrode. In addition, the N electrode may be electrically connected to a middle part of the N-type region layer 2114, so that electrons of the pixel unit 24 do not easily flow to edges of the subpixels, thereby reducing a risk of current leakage of the subpixels.

Alternatively, based on a same concept, the multi-quantum-well layer 214 and the N-type region layer 2114 may be cut, and the P-type region layer 2115 is retained as an integrated P-type region layer. Details are not described herein again.

FIG. 15 is a schematic diagram of a structure of a pixel unit according to an embodiment of this application. In another specific embodiment, the barrier between subpixels may be an aluminum light shielding barrier. In this case, when the wafer is prepared in step S101, the LED layer 21 is cut to form a plurality of LEDs 218, and then an aluminum light shielding barrier is prepared between LEDs 218. Specifically, an ohmic contact layer 2117 may be first prepared on a surface of the LED layer 21, then the LED layer 21 is cut to form the plurality of LEDs 218, and then an insulation layer 2118 is prepared on an outer surface of each LED 218, and a through hole is prepared on a surface of the insulation layer 2118. An aluminum light shielding barrier 2116 is prepared on an outer surface of the insulation layer 2118, the aluminum light shielding barrier 2116 is electrically connected to an end of the LED 218 through the through hole and the ohmic contact layer 2117, and the aluminum light shielding barrier 2116 is etched to form a conducting pattern. A color function layer 2110 is prepared outside the aluminum light shielding barrier 2116, and then the aluminum light shielding barrier is further completed to isolate color function layers 2110 of subpixels. Then a passivation layer 25 is prepared on an outer surface of the pixel unit 24, and the pixel unit 24 is formed through packaging. A surface of the aluminum light shielding barrier has a high light reflectivity. Therefore, when light emitted by the subpixel reaches the aluminum light shielding barrier, more light is reflected into the subpixel. This helps improve brightness and light emitting efficiency of the subpixel.

Further, a first electrode 22 and a second electrode 23 may be prepared on a side of the pixel unit 24, and the aluminum light shielding barrier is electrically connected to the first electrode 22 or the second electrode 23. In this solution, the aluminum shielding barrier serves as a conducting wire. This can reduce a quantity of conducting wires disposed when the pixel unit 24 is prepared, thereby simplifying a process and reducing costs. When the first electrode 22 and the second electrode 23 of the pixel unit 24 are located on a same side of the subpixels, one of the first electrode 22 and the second electrode 23 needs to be connected to the LED layer 21 by using a wire passing through a thickness direction of the LED layer 21. Specifically, the aluminum light shielding barrier may be electrically connected to the electrode that needs to be connected to the wire passing through the thickness direction of the LED layer 21, so that no additional conducting wire passing through the LED layer 21 needs to be prepared. This helps increase an occupancy proportion of the LEDs in the display panel, and helps improve light emitting efficiency and a display effect.

Alternatively, all subpixels of each pixel unit 24 may be designed to share one electrode. To be specific, one ends of all the subpixels of the pixel unit 24 share one second electrode 23, and the other ends of the subpixels each are connected to one first electrode 22. When the aluminum light shielding barrier is disposed between adjacent subpixels, the aluminum light shielding barrier may be connected to the second electrode 23, so that one ends of the subpixels of the pixel unit 24 share one second electrode 23. In this case, the aluminum light shielding barrier may further serve as a wire for connecting to the shared electrode to reduce additional conducting wires.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A display panel, comprising a plurality of pixel units, wherein the pixel units comprise at least three color subpixels, the at least three color subpixels are packaged into one pixel unit by a passivation layer, one ends of the subpixels of the pixel unit each are connected to one first electrode, and the other ends of the subpixels of the pixel unit share one second electrode.

2. The display panel according to claim 1, wherein each of the subpixels comprises at least two sub-subpixels, and the at least two sub-subpixels are arranged in parallel.

3. The display panel according to claim 1, wherein the pixel unit comprises at least a red subpixel and a green subpixel, and a quantity of red subpixels may be greater than a quantity of green subpixels.

4. The display panel according to claim 1, wherein an aluminum light shielding barrier may be disposed on peripheries of the subpixels.

5. The display panel according to claim 4, wherein the aluminum light shielding barrier may be connected to the first electrode or the second electrode of the subpixels.

6. The display panel according to claim 1, wherein the pixel unit comprises an LED layer and a color function layer, and the LED layer comprises an N-type region layer, a multi-quantum-well layer, and a P-type region layer that are sequentially arranged, wherein
in adjacent subpixels of the pixel unit, there is a light shielding barrier between the multi-quantum-well layer and the P-type region layer, and the N-type region layer of the pixel unit is an integrated N-type region layer; or
in adjacent subpixels of the pixel unit, there is a light shielding barrier between the multi-quantum-well layer and the N-type region layer, and the P-type region layer of the pixel unit may be an integrated P-type region layer.

7. The display panel according to claim 1, wherein the pixel unit comprises an LED layer and a color function layer, and comprises a reflection layer on a side, of the LED layer, that is away from the color function layer.

8. The display panel according to claim 1, wherein the pixel unit comprises an LED layer and a color function layer, and comprises a second distributed Bragg reflector layer on a side, of the LED layer, that faces the color function layer.

9. A display apparatus, comprising a middle frame, a rear housing, a printed circuit board, and the display panel according to any one of claims 1 to 8, wherein
the middle frame is configured to carry the printed circuit board and the display panel, the printed circuit board and the display panel are disposed on two sides of the middle frame, and the rear housing is mounted on a side, of the printed circuit board, that is away from the middle frame.

10. A preparation method for a display panel, comprising:
preparing a wafer, wherein the wafer comprises an LED layer;
preparing a color function layer on a surface of the LED layer to form subpixels of a plurality of colors;
obtaining, through cutting, a barrier between pixel units to form a plurality of independent pixel units, wherein the pixel unit comprises subpixels of at least three colors;
preparing a passivation layer on an outer surface of the pixel unit, and packaging subpixels of the pixel unit; and
transferring a pixel unit with the passivation layer to a substrate with a drive circuit.

11. The preparation method for the display panel according to claim 10, wherein the preparing a wafer comprises:
preparing the LED layer on a surface of the substrate, wherein a side, of the LED layer, that is away from the substrate is a reflection layer; and
forming the first electrode and the second electrode on a surface, of the reflection layer, that is away from the substrate.

12. The preparation method for the display panel according to claim 10, wherein the preparing a wafer comprises:
preparing a second distributed Bragg reflector layer on a side, of the LED layer, that faces the color function layer.

13. The preparation method for the display panel according to claim 10, wherein the preparing a wafer comprises:
preparing an insulation layer at a specified position of each LED by using an ion implantation process, so that at least two parallel sub-LEDs are formed for the LED; and
performing cutting at a specified position of each LED, so that at least two parallel sub-LEDs are formed for the LED.

14. The preparation method for the display panel according to claim 10, wherein
the preparing a wafer comprises: cutting the LED layer to form a plurality of LEDs, and preparing an aluminum light barrier between LEDs; and
the preparing a color function layer on a surface of the LED layer to form subpixels of a plurality of colors comprises: preparing an aluminum light shielding barrier between subpixels.

15. The preparation method for the display panel according to claim 14, wherein the aluminum light shielding barrier is electrically connected to the first electrode or the second electrode of the subpixel.

16. The preparation method for the display panel according to claim 10, wherein the preparing a wafer comprises:
preparing the LED layer, wherein the LED layer comprises an N-type region layer, a multi-quantum-well layer, and a P-type region layer that are sequentially arranged; and
cutting the N-type region layer and the multi-quantum-well layer;
or
preparing the LED layer, wherein the LED layer comprises an N-type region layer, a multi-quantum-well layer, and a P-type region layer that are sequentially arranged; and
cutting the P-type region layer and the multi-quantum-well layer.

17. The preparation method for the display panel according to claim 10, wherein the pixel unit comprises at least a red subpixel and a green subpixel, and a quantity of red subpixels may be greater than a quantity of green subpixels.

18. The preparation method for the display panel according to claim 10, wherein one ends of the subpixels of the pixel unit each are connected to one first electrode, and the other ends of the subpixels of the pixel unit share one second electrode.
